# FASCICULE DE BREVET EUROPEEN

(11) **EP 3 155 884 B1**
(45) Date de publication et mention de la délivrance du brevet: **20.05.2020**
(21) Numéro de dépôt: 15736543.8
(22) Date de dépôt: 08.06.2015
(51) Int. Cl.: H05K 9/00

(54) **JOINT DE BLINDAGE ELECTROMAGNETIQUE**
VERBINDUNG MIT ELEKTROMAGNETISCHER ABSCHIRMUNG
ELECTROMAGNETIC SHIELDING JOINT

(30) Priorité: 13.06.2014 FR 1455387
(43) Date de publication de la demande: 19.04.2017
(73) Titulaire: Getelec, 78530 Buc (FR)
(72) Inventeur: DUSSAILLY, François, F-78470 Saint Rémy les Chevreuses (FR)
(74) Mandataire: Mazabraud, Xavier
(86) Numéro de dépôt international: PCT/FR2015/051512
(87) Numéro de publication internationale: WO 2015/189510

(56) Documents cités:
- EP-A1- 2 073 619
- EP-A2- 0 340 773
- US-A- 3 783 173
- US-A- 5 068 493
- US-B1- 7 288 727

## Description

L'invention se situe dans le domaine des moyens de blindage électromagnétique, notamment des joints de blindage pour coffrets et boîtiers, en particulier dans le domaine des hyperfréquences.

La compatibilité électromagnétique (CEM) est l'aptitude d'un appareil ou d'un système électrique ou électronique à fonctionner dans son environnement électromagnétique de façon satisfaisante, et sans produire lui-même des perturbations électromagnétiques pour tout ce qui se trouve dans cet environnement.

Une bonne compatibilité électromagnétique décrit un état de « bon voisinage électromagnétique » :
- limiter le niveau des émissions non désirées provenant de l'appareil, afin de ne pas perturber la réception radio ou les autres équipements ;
- être suffisamment immunisé contre les perturbations provenant des autres équipements, ou plus généralement de l'environnement.

Le blindage électromagnétique d'un équipement remplit donc deux fonctions :
- atténuer le champ électromagnétique émis par un équipement en vue de ne pas perturber son environnement,
- atténuer les champs électromagnétiques reçus par les composants électroniques à l'intérieur de cet équipement de façon à ne pas être perturbé par son environnement.

On sait que le blindage électromagnétique d'un équipement est d'autant plus difficile à réaliser que celui-ci utilise des fréquences plus élevées. En effet, plus la fréquence est élevée, plus les conducteurs ont la capacité de se transformer en antennes d'émission ou de réception. Plus les dimensions d'un conducteur se rapprochent des dimensions idéales d'une antenne (fraction entière ou multiple de la longueur d'onde), plus il rayonne ou est susceptible d'absorber de l'énergie électromagnétique.

Lorsqu'une électronique est enfermée dans un boîtier, celui-ci est généralement réalisé dans un matériau conducteur, par exemple métallique, et joue donc le rôle de cage de Faraday. Dans ce cas, la principale source d'émission et de pénétration de parasites électromagnétiques est constituée par la jonction entre deux éléments dissociables du boîtier, par exemple le corps du boîtier et un couvercle ou une porte, qui présente une ouverture ou une fente. Or une fente dont le périmètre est proche d'une longueur d'onde constitue une antenne accordée sur la fréquence correspondante.

Certaines applications telles que l'aéronautique, les radars civils et militaires, les télécommunications, travaillent dans le domaine des hyperfréquences, c'est-à-dire environ 500 MHz à 500 GHz. Obtenir un blindage de bonne qualité d'une électronique en hyperfréquences est difficile. L'état de l'art propose plusieurs réponses, notamment des joints en matériau polymère conducteur. Lors de la fermeture du coffret muni d'un tel joint, le joint s'écrase sur les bords des éléments du coffret venant en regard l'un de l'autre et assure une bonne continuité électrique entre ces éléments. En revanche, un tel joint est difficile à manipuler car il manque de rigidité.

Le document US 7 288 727 (Garcia Jorge) décrit un tel joint, plat, comprenant une lame métallique prise entre deux bandes de polymère. Le document US 5 068 493 (Benn sr Robert et Al.) décrit un joint de section complexe en polymère chargé en carbone, dont une partie est recouverte d'un polymère chargé en métal.

Pour résoudre ce problème, l'invention propose un joint de blindage électromagnétique pour assurer la continuité d'un blindage à la jonction de deux éléments de blindage, caractérisé en ce qu'il comporte :
- au moins un élément profilé constitué d'un premier matériau polymère électriquement conducteur,
- au moins une lame métallique fixée sur ledit élément profilé par une première face,
- au moins une bande constituée d'un second matériau polymère électriquement conducteur, fixée sur une seconde face de ladite lame métallique, ladite lame formant une semelle pour ledit joint.
l'élément profilé présentant une section sensiblement en forme de U, la lame métallique étant fixée sur l'extrémité des branches du U.

Dans un mode de réalisation préféré, le joint comporte une lame métallique prise en sandwich entre un élément profilé et une bande formant semelle.

La lame métallique procure de la rigidité au joint tout en participant à sa conductivité.

Avantageusement, la lame métallique peut comporter du Béryllium.

La lame peut être réalisée en un alliage de Béryllium, par exemple un bronze Cuivre - Béryllium. Ce métal est choisi pour ses propriétés de rigidité et sa bonne conductivité.

Différents matériaux polymères conducteurs sont connus. Avantageusement, le premier et/ou le second matériau polymère peuvent comporter une matière silicone chargée en cuivre argenté et, de préférence, la bande est réalisée dans le même matériau que l'élément profilé.

Avantageusement, la fixation de la lame métallique sur l'élément profilé et sur la bande formant semelle peut faire intervenir une couche de matériau polymère électriquement conducteur pâteux.

De cette façon, on n'introduit pas d'autre matériau (colle...) qui serait susceptible de créer une discontinuité dans la conductivité du joint. La couche de matériau polymère pâteux peut être soit ajoutée, soit résulter d'un chauffage superficiel de l'élément profilé et/ou de la semelle. Bien entendu, cette couche pâteuse est avantageusement composée du même matériau que l'élément profilé et la semelle.

Avantageusement, la lame métallique peut comporter des moyens de fixation sur un élément de blindage.

Dans un mode de réalisation préféré, ces moyens de fixation peuvent comporter des pattes qui s'étendent sur les bords de la lame métallique et qui s'écartent du plan de ladite lame d'un angle déterminé.

La semelle est prévue pour prendre place dans une rainure ménagée sur un élément de blindage, par exemple la porte d'un coffret. Les pattes sont prévues pour s'insérer dans des fentes ménagées d'un côté et/ou de l'autre de la rainure.

Avantageusement, le joint peut former au moins une boucle fermée.

Le joint selon l'invention peut être produit linéairement et découpé à la demande, mais sa mise en place dans la rainure de l'élément à blinder laisserait une fente entre les deux extrémités du joint, inacceptable dans les conditions d'environnement électromagnétique sévères auxquelles il est destiné. En conséquence, lorsque le joint est prévu pour assurer le blindage de la jonction entre deux éléments de blindage dont l'un possède au moins une ouverture, par exemple un coffret et une porte prévue pour fermer cette ouverture, le joint est de préférence fabriqué à la mesure et aux formes de la rainure entourant au moins une ouverture, et forme donc au moins une boucle fermée.

L'invention porte également sur une enceinte de blindage comportant deux parties distinctes et un joint de blindage selon l'invention entre les deux dites parties.

L'enceinte est par exemple un coffret ou un boitier renfermant une électronique sensible aux et/ou travaillant dans le domaine des hyper - fréquences et qui constitue en soi un blindage de cette électronique, par exemple parce qu'il est métallique. Cette enceinte comporte une ouverture qui doit être fermée de façon parfaitement étanche aux hyper - fréquences par un couvercle ou une porte. Le joint de blindage selon l'invention s'intercale entre le corps du coffret et le moyen de fermeture et assure cette étanchéité lorsqu'il est écrasé entre le corps du coffret et le moyen de fermeture.

L'invention porte également sur un procédé de fabrication d'un joint de blindage selon l'invention, comportant les étapes consistant à :
- mouler au moins un profilé en matériau polymère électriquement conducteur,
- fabriquer au moins une lame métallique de même largeur que ledit profilé ou de largeur très légèrement supérieure,
- déposer une première couche de matériau polymère électriquement conducteur pâteux sur une première face de ladite lame métallique,
- déposer une deuxième couche de matériau polymère électriquement conducteur pâteux dans une rainure de façon à former une bande de même largeur que ledit profilé,
- appliquer la seconde face de ladite lame métallique sur ladite deuxième couche de matériau polymère pâteux et appliquer ledit profilé sur ladite première couche de matériau polymère pâteux,
- chauffer et appliquer une pression.

Des modes de réalisation et des variantes seront décrits ci-après, à titre d'exemples non limitatifs, avec référence aux dessins annexés dans lesquels :
Les figures 1A et 1B représentent respectivement une coupe transversale courante du joint et une coupe transversale au niveau d'un moyen de fixation,
La figure 2 représente une vue éclatée du joint en ses trois composants,
La figure 3 représente une étape de fabrication du joint.

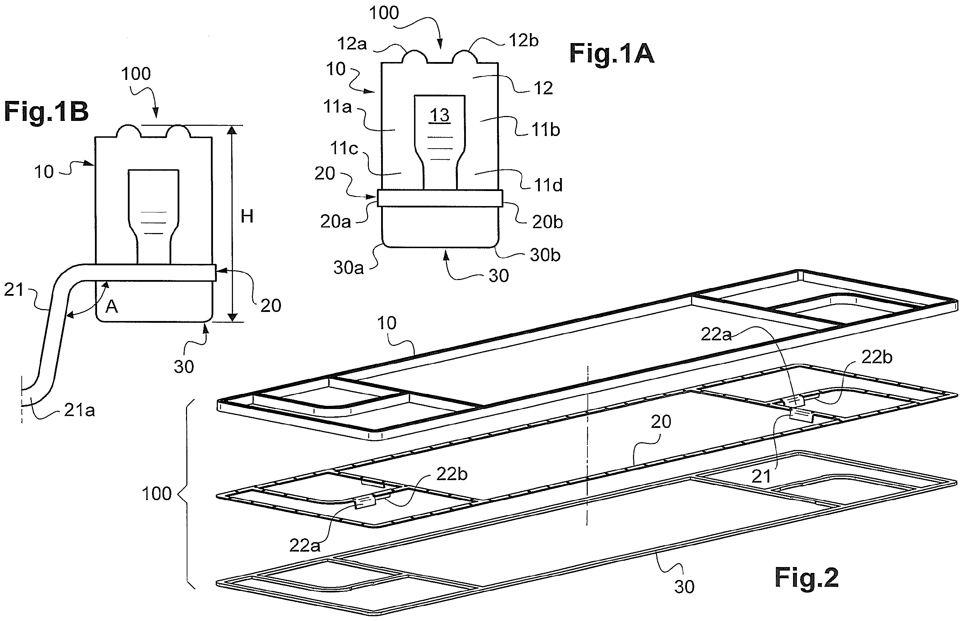

La figure 1A illustre une coupe transversale courante d'un joint 100 selon l'invention. Ce type de joint est prévu pour prendre place dans deux rainures se faisant face à la jonction de deux éléments de blindage, par exemple un coffret et un moyen de fermeture de ce coffret, tel qu'un couvercle ou une porte. Il comporte trois éléments qui vont être décrits ci-après.

Le joint comporte un profilé 10 qui présente une section sensiblement en forme de U, comportant deux branches latérales 11a, 11b, épaisses et dont les faces externes sont planes, et un fond 12 sensiblement rectiligne, orthogonal aux branches du U. Les branches et le fond du U délimitent ainsi une partie intérieure creuse 13. Ce profilé est réalisé en silicone rendu conducteur par l'inclusion de particules métalliques, notamment des particules de cuivre argenté. Les particules de cuivre argenté ont par exemple un diamètre compris entre 10 et 40 microns. Un joint composé d'un tel matériau possède une efficacité de blindage de 114 à 120 dB à 10 GHz.

L'extrémité des branches du U comportent une partie de plus grande épaisseur 11c, 11d au voisinage de leur extrémité, grâce à un renflement tourné vers l'intérieur 13 du U, si bien que ces extrémités sont élargies par rapport au reste des branches 1 1a, 11b.

La face externe du fond 12 comporte deux excroissances 12a, 12b s'étendent sur toute la longueur de l'élément profilé 10 et destinées à assurer un bon contact avec le fond d'une rainure dans laquelle il est amené à prendre place.

Une lame métallique ou clinquant 20 est fixée par une première face sur l'extrémité des branches 11a, 11b du U, sur la partie de plus grande épaisseur 11c, 11d. Il s'étend sur toute la longueur de l'élément profilé 10.

Comme il est visible sur la figure 1A, l'extension transversale ou largeur de la lame métallique 20 est légèrement supérieure à celle de l'élément profilé 10, les bords 20a, 20b de la lame s'écartant légèrement de la face latérale externe des branches 11a, 11b du U, de façon procurer un moyen de prise pour l'utilisateur. Par légèrement supérieure on entend de 5 à 10 %.

Sur une deuxième face de la lame 20 est fixée une bande 30 également en silicone conducteur, du même matériau que l'élément profilé et formant semelle pour le joint. Cette semelle s'étend également sur toute la longueur de l'élément profilé.

La section de cette semelle 30 est sensiblement rectangulaire, elle est fixée sur la lame métallique par un grand côté. Sa largeur est égale à celle du profilé 10. Les coins 30a, 30b de la semelle opposés à la lame métallique sont arrondis. L'épaisseur de la semelle 30 est supérieure à celle des branches 11a, 1 1b et à celle du fond 12 du U.

La lame métallique 20 est donc prise en sandwich entre l'élément profilé et la semelle 30.

La figure 1B illustre une coupe transversale du joint 100 au niveau d'une patte de fixation 21. Les pattes de fixation sont destinées à s'insérer dans des fentes prévues sur un/les bord(s) de la rainure dans laquelle la semelle 30 du joint 100 doit s'insérer ; elles servent à faciliter le positionnement du joint au moment de sa pose et à le maintenir en place. Les pattes s'insèrent avec friction dans les fentes, leur installation est donc réversible.

Les pattes de fixation 21, 22a, 22b s'étendent sur une longueur limitée sur un bord 20a, 20b de la lame métallique, par exemple 2 à 3 fois la largeur totale du joint 100. Elles s'écartent du plan de la lame métallique d'un angle A égal à 90° sur la figure 1B mais pouvant avantageusement être compris entre 90 et 130°.

Comme illustré en figure 1B, l'extrémité libre de la patte 21 présente une partie courbée 21a dans une direction opposée au reste du joint. Cette partie courbée a pour fonction d'augmenter la friction lors de l'introduction de la patte de fixation 21 dans une fente. Dans d'autres modes de réalisation, cette partie courbée est absente.

La fixation de la lame métallique sur le profilé et de la semelle sur la lame métallique est réalisée à l'aide d'une couche pâteuse de la matière conductrice, de préférence de la même matière que le profilé et que la semelle, de façon à ne pas introduire d'autre composant tel qu'une colle qui pourrait venir interrompre ou dégrader la continuité de la conductivité entre le profilé 10 et la semelle 30.

L'épaisseur totale du joint, depuis les excroissances 12a, 12b jusqu'à la face libre de la semelle 30 est notée H.

On a trouvé que la forme décrite ci-dessus donnée au joint 100 assurait une bonne continuité électrique lorsque le joint était écrasé.

La figure 2 est une vue éclatée d'une réalisation de joint 100 en vue d'une application particulière, les trois composants étant séparés les uns des autres. Dans l'exemple illustré le joint 100 a une forme générale de rectangle cloisonné mais toute autre forme est bien sûr réalisable.

La lame métallique ou clinquant 20 comporte des pattes de fixation 21, 22a, 22b. Ces pattes de fixation vont en fait par paire, les pattes d'une paire 22a, 22b étant situées de part et d'autre de la lame métallique, décalées l'une par rapport à l'autre d'une distance d égale à une fraction de la longueur d'une patte.

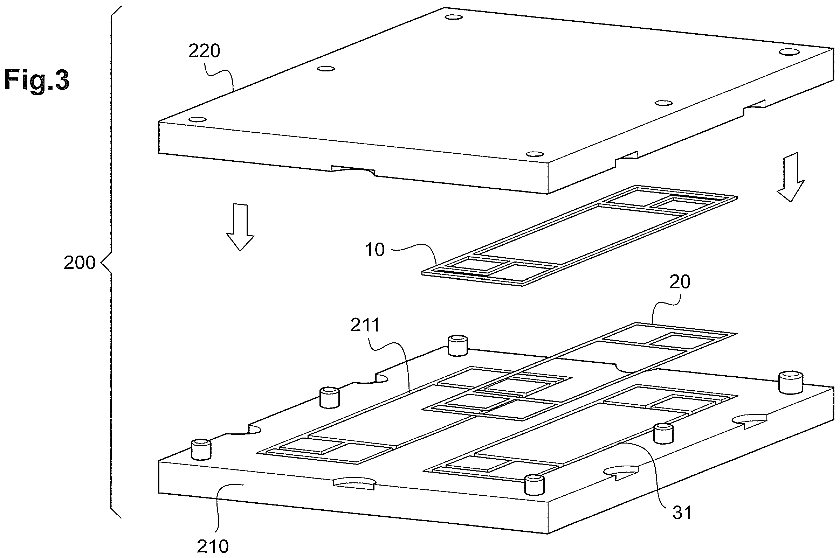

Le procédé de fabrication illustré en figure 3 du joint fait avantageusement intervenir un moule 200 comportant deux parties, une partie inférieure ou socle 210, comportant une première rainure 211 pour mouler la bande 30, et une partie supérieure ou couvercle 220 comportant une seconde rainure (non visible) pour mouler le profilé 10. Lorsqu'on referme le moule 200, les première et seconde rainures viennent en regard.

Le matériau utilisé en tant que matière première est pâteux et durcit à la cuisson.

Dans un premier temps, on fabrique le profilé 10 à l'aide de la partie supérieure 220 du moule, puis la lame métallique 20, par exemple par emboutissage.

On dépose ensuite une fine couche de matériau polymère sur la face supérieure de la lame métallique 20 et on dépose une couche 31 de matériau pâteux dans la rainure 211 du socle en vue de former la bande 30.

On referme le moule 200, avec la lame métallique prise entre ses deux parties, de façon à prendre en sandwich la lame métallique entre le profilé 10 et la bande 30. On applique une pression et on chauffe, ce qui durcit le polymère et assemble les trois éléments du joint 100.

Les dimensions typiques d'un joint selon l'invention sont par exemple les suivantes :
Hauteur totale H : 2,4 mm,

Largeur totale, c'est-à-dire entre les bords 20a, 20b de la lame 20 : 1,5 mm,

Largeur du profilé et de la semelle : 1,4 mm,
Epaisseur de la lame métallique : 0,2 mm,
Extension longitudinale d'une patte 21 : 5 mm,
Extension transversale d'une patte 21 : 1,2 mm,
Décalage longitudinal d entre deux pattes 22a, 22b d'une paire : 1,6 mm, Valeur de l'angle A : 100°.

Bien sûr, ces dimensions sont purement indicatives et n'ont aucune valeur limitative.

L'invention n'est pas limitée par la description que précède. En particulier :
- la lame métallique pourrait ne pas comporter de Béryllium mais un autre métal moins cher et moins dangereux à travailler,
   - le joint pourrait comporter plusieurs lames métalliques prises en sandwich entre des couches de matériau polymère conducteur.
   - le joint pourrait comporter plusieurs lames métalliques prises en sandwich entre des couches de matériau polymère conducteur.

## Revendications

1. Joint de blindage électromagnétique (100) pour assurer la continuité d'un blindage à la jonction de deux éléments de blindage, comportant :
- au moins un élément profilé (10) constitué d'un premier matériau polymère électriquement conducteur,
- au moins une lame métallique (20) fixée sur ledit élément profilé par une première face, et,
- au moins une bande (30) constituée d'un second matériau polymère électriquement conducteur, fixée sur une seconde face de ladite lame métallique, ladite lame formant une semelle pour ledit joint, **caractérisé en ce que** l'élément profilé (10) présente une section sensiblement en forme de U, la lame métallique (20) étant fixée sur l'extrémité des branches (lia, 11b) du U.

2. Joint de blindage selon la revendication 1,
**caractérisé en ce que** le premier et/ou le second matériau polymère comporte une matière silicone chargée en cuivre argenté.

3. Joint de blindage selon l'une des revendications 1 et 2,
**caractérisé en ce que** la bande (30) est réalisée dans le même matériau que l'élément profilé (10).

4. Joint de blindage selon la revendication 3,
**caractérisé en ce que** l'épaisseur de la bande (30) est supérieure à celle d'une paroi de l'élément profilé (10).

5. Joint de blindage selon l'une des revendications précédentes, **caractérisé en ce que** la largeur de la lame métallique (20) est légèrement supérieure à celle de l'élément profilé (10).

6. Joint de blindage selon l'une des revendications précédentes, **caractérisé en ce que** la lame métallique (20) comporte du Béryllium.

7. Joint de blindage selon l'une des revendications précédentes, **caractérisé en ce que** la fixation de la lame métallique (20) sur l'élément profilé (10) et sur la bande formant semelle (30) fait intervenir une couche de matériau polymère électriquement conducteur pâteux.

8. Joint de blindage selon l'une des revendications précédentes, **caractérisé en ce que** la lame métallique (20) comporte des moyens de fixation sur un élément de blindage.

9. Joint de blindage selon la revendication 8,
**caractérisé en ce que** les moyens de fixation comportent des pattes (21, 22a, 22b) qui s'étendent sur les bords (20a, 20b) de la lame métallique (20) et qui s'écartent du plan de ladite lame d'un angle déterminé (A).

10. Joint de blindage selon l'une des revendications précédentes, **caractérisé en ce qu'**il forme au moins une boucle fermée.

11. Enceinte de blindage comportant deux parties distinctes et un joint de blindage (100) selon l'une des revendications précédentes entre les deux dites parties.

## Patentansprüche

1. Verbindung mit elektromagnetischer Abschirmung (100) zur Gewährleistung der Kontinuität einer Abschirmung an der Verbindungsstelle zweier Abschirmelemente, umfassend:
- mindestens ein Profilelement (10), das aus einem ersten elektrisch leitenden Polymermaterial besteht,
- mindestens einen Metallstreifen (20), der mit einer ersten Seite an dem Profilelement befestigt ist, und
- mindestens ein Band (30) aus einem zweiten elektrisch leitenden Polymermaterial, das an einer zweiten Seite des Metallstreifens befestigt ist, wobei der Streifen eine Sohle für die Verbindung bildet, **dadurch gekennzeichnet, dass** das Profilelement (10) einen im Wesentlichen U-förmigen Querschnitt aufweist, wobei der Metallstreifen (20) an den Enden der Schenkel (11a, 11b) des U befestigt ist.

2. Verbindung mit Abschirmung nach Anspruch 1,
**dadurch gekennzeichnet, dass** das erste und/oder zweite Polymermaterial ein mit versilbertem Kupfer beladenes Silikonmaterial umfasst.

3. Verbindung mit Abschirmung nach einem der Ansprüche 1 und 2,
**dadurch gekennzeichnet, dass** das Band (30) aus dem gleichen Material wie das Profilelement (10) besteht.

4. Verbindung mit Abschirmung nach Anspruch 3,
**dadurch gekennzeichnet, dass** die Dicke des Bandes (30) größer ist als die einer Wand des Profilelements (10).

5. Verbindung mit Abschirmung nach einem der vorangehenden Ansprüche,
**dadurch gekennzeichnet, dass** die Breite des Metallstreifens (20) geringfügig größer ist als jene des Profilelements (10).

6. Verbindung mit Abschirmung nach einem der vorangehenden Ansprüche,
**dadurch gekennzeichnet, dass** der Metallstreifen (20) Beryllium enthält.

7. Verbindung mit Abschirmung nach einem der vorangehenden Ansprüche,
**dadurch gekennzeichnet, dass** in die Befestigung des Metallstreifens (20) an dem Profilelement (10) und an dem die Sohle bildenden Band (30) eine Schicht aus einem pastösen elektrisch leitenden Polymermaterial einbezogen ist.

8. Verbindung mit Abschirmung nach einem der vorangehenden Ansprüche, **dadurch gekennzeichnet, dass** der Metallstreifen (20) Mittel zum Befestigen an einem Abschirmungselement aufweist.

9. Verbindung mit Abschirmung nach Anspruch 8,
**dadurch gekennzeichnet, dass** die Befestigungsmittel (21, 22a, 22b) Laschen umfassen, die sich entlang der Ränder (20a, 20b) des Metallstreifens (20) erstrecken und die von der Ebene des Streifens in einen bestimmten Winkel (A) abstehen.

10. Verbindung mit Abschirmung nach einem der vorangehenden Ansprüche,
**dadurch gekennzeichnet, dass** diese mindestens eine geschlossene Schleife bildet.

11. Abschirmungsumhüllung umfassend zwei getrennte Teile und eine Verbindung mit Abschirmung (100) nach einem der vorangehenden Ansprüche zwischen den beiden Teilen.

## Claims

1. Electromagnetic shielding gasket (100) for ensuring the continuity of a shielding at the junction of two shielding elements, including:
- at least one profiled element (10) consisting of a first electrically conductive polymer material,
- at least one metal strip (20) fastened onto said profiled element by a first face, and
- at least one band (30) consisting of a second electrically conductive polymer material, fastened onto a second face of said metal strip, said strip forming a sole for said gasket,
**characterised in that** the profiled element (10) has a substantially U-shaped cross-section, the metal strip (20) being fastened onto the end of the legs (11a, 11b) of the U.

2. Shielding gasket according to claim 1,
**characterised in that** the first and/or the second polymer material includes a silicone material loaded with silver-bearing copper.

3. Shielding gasket according to one of claims 1 and 2,
**characterised in that** the band (30) is made from the same material as the profiled element (10).

4. Shielding gasket according to claim 3,
**characterised in that** the thickness of the band (30) is greater than that of a wall of the profiled element (10).

5. Shielding gasket according to one of the previous claims,
**characterised in that** the width of the metal strip (20) is slightly greater than that of the profile element (10).

6. Shielding gasket according to one of the previous claims,
**characterised in that** the metal strip (20) includes beryllium.

7. Shielding gasket according to one of the previous claims,
**characterised in that** the fastening of the metal strip (20) onto the profiled element (10) and onto the band forming a sole (30) involves using a layer of paste-like electrically conductive polymer material.

8. Shielding gasket according to one of the previous claims,
**characterised in that** the metal strip (20) includes means for fastening onto a shielding element.

9. Shielding gasket according to claim 8,
**characterised in that** the fastening means include lugs (21, 22a, 22b) that extend on the edges (20a, 20b) of the metal strip (20) and that move away from the plane of said strip by a determined angle (A).

10. Shielding gasket according to one of the previous claims,
**characterised in that** it forms at least one closed loop.

11. Shielding enclosure including two distinct parts and a shielding gasket (100) according to one of the previous claims between said two parts.
